# EUROPÄISCHE PATENTSCHRIFT

(11) **EP 1 347 578 B1**
(45) Veröffentlichungstag und Bekanntmachung des Hinweises auf die Patenterteilung: **15.08.2007**
(21) Anmeldenummer: 02006730.2
(22) Anmeldetag: 23.03.2002
(51) Int. Cl.: H03L 7/00, G06F 1/10

(54) **Taktschema und Takteinrichtung für eine monolitisch integrierte Schaltung**
Clocking scheme and clock device for a monolithic integrated circuit
Architecture d'horloge et dispositif d'horloge pour circuit intégré monolithique

(43) Veröffentlichungstag der Anmeldung: 24.09.2003
(73) Patentinhaber: Micronas GmbH, 79108 Freiburg i. Br. (DE)
(72) Erfinder: Häringer, Helmut, 79297 Winden i.E. (DE); Schidlack, Erik, Dipl.-Ing., 79100 Freiburg (DE)
(74) Vertreter: Neunert, Peter Andreas

(56) Entgegenhaltungen:
- EP-A- 0 274 606
- WO-A-02/01233
- US-A- 5 929 683

## Beschreibung

Die Erfindung betrifft ein Verfahren und eine Taktvorrichtung für eine monolithisch integrierte Schaltung gemäß dem Oberbegriff des Anspruchs 1 bzw. 2.

Eine solches Verfahren und eine solche Taktvorrictung sind z.B. aus EP 0 274 606 A1 bekannt.

Da die Komplexität, der Umfang und die Signalverarbeitungsgeschwindigkeit derartiger Schaltungen laufend zunimmt, tritt in der Anwendung immer häufiger das Problem auf, daß die Schaltungen leider auch als große elektromagnetische Störquelle wirksam sind. Und dies nicht nur im Umfeld gegenüber mehr oder weniger benachbarten Schaltungen, sondern auch als Störquellen gegen sich selbst. Dies insbesondere dann, wenn außer den rein digitalen Signalverarbeitungsstufen auch analoge Stufen mitintegriert sind. Oft befinden sich diese im Eingangsbereich, in dem noch analoge Signale zu verarbeiten sind. Analoge Stufen sind beispielsweise Eingangsverstärker, Analog-Digitalumsetzer oder Mischer usw. Störungen wirken sich hierbei besonders unangenehm aus, weil die Störungen und deren Oberwellen direkt oder über ihre Mischprodukte in das Nutzsignal fallen können, dessen Signalamplituden noch sehr klein sind. Eine Überlagerung von zusätzlichen Störsignalen kann sich daher sofort bemerkbar machen und die Funktionsweise der Gesamtschaltung erheblich stören.

Hauptquelle für die Störungen sind die hohen Stromspitzen, die bei der synchronen Signalverarbeitung direkt mit dem Systemtakt verkoppelt sind, durch den sehr viele Schaltvorgänge gleichzeitig ausgelöst werden. Bei Schaltungen, die mit einer Komplementär-Schaltungstechnik, wie z.B. CMOS, arbeiten, werden durch die Taktflanken die Gate-Kapazitäten der angesteuerten Schalttransistoren aufgeladen oder entladen. Dabei löst die Arbeitsflanke des Systemtaktes alle synchronen Schaltvorgänge aus, denen dann während dieses Arbeitstaktes noch mehr oder weniger viele asynchron ablaufende Schaltvorgänge folgen. Alle Schaltvorgänge müssen rechtzeitig vor der neuen Arbeitsflanke des Systemtaktes abgeschlossen sein. Gleichzeitig mit dem Auf- und Entladen der Gate-Kapazitäten werden auch Diffusions- und Leitungskapazitäten auf- oder entladen. Alle synchron ausgelösten Auf- oder Entladungen addieren sich auf den internen und externen Takt- und Versorgungsleitungen zu steilen Stromspitzen, die über die externen Versorgungsleitungen aber auch über die extern angeschlossenen Datenleitungen elektromagnetische und kapazitive Störsignale erzeugen.

Die Grundfrequenz dieser Störsignale ist in der Regel die Taktfrequenz. Wegen der großen Flankensteilheit der Stromspitzen ergeben sich entsprechend viele, starke Oberwellen. Den Nachteil dieser gleichzeitig stattfindenden Schaltvorgänge kann man mit asynchronen Schaltwerken im Prinzip vermeiden, diese sind aber weit aufwendiger bei der Schaltungs- und Layoutentwicklung. Außerdem gibt es kaum Softwarewerkzeuge, die ein asynchrones Design unterstützen. Weitere, bekannte Maßnahmen zur Reduzierung der intemen und externen Störungen sind beispielsweise folgende:
1. Eine günstige Anordnung der Versorgungsanschlüsse, durch die eine einfache externe Abblockung mit Siebmitteln wie Kondensatoren oder Ferritmaterialien ermöglicht wird.
2. Interne Abblockmaßnahmen, beispielsweise durch mitintegrierte Abblockkondensatoren.
3. Interne und externe Abschirmmaßnahmen durch Masseleitungen.
4. Geregelte Ausgangsstufen, um die An- und Abstiegszeiten der Schalt- oder Datenflanken nicht zu steil werden zu lassen.
5. Möglichst geringe interne kapazitive Lasten für die Auf- und Entladung.
6. Modulation der Taktfrequenz mit einem vorgegebenen oder zufälligen Signal.

Diese Maßnahmen helfen in vielen Fällen, insbesondere wenn es sich um unkritische Schaltungen handelt. Bei besonders kritischen Schaltungen reicht ihre Wirksamkeit jedoch nicht aus.

Es ist daher Aufgabe der Erfindung, die bekannte synchrone Schaltungstechnik dahingehend weiterzubilden, daß die intern und extern wirkenden Störungen auch bei relativ umfangreichen monolithisch integrierten Schaltungen weniger wirksam werden.

Die Lösung dieser Aufgabe besteht in einem Verfahren nach Anspruch 1 oder in einer Tackvorrichtung nach Anspruch 2.

Das Verfahren geht dabei von einem von einer Taktquelle erzeugten Grundtakt aus, der mit N gegeneinander verzögerten Zwischentakten gekoppelt ist, wobei die einzelnen Verzögerungen innerhalb einer Periode T des Grundtaktes verteilt sind. Jeder der N Zwischentakte speist dabei mindestens einen von M Datenverarbeitungsblöcken der monolithisch integrierten Schaltung. Damit die Datenübergabe zwischen einem sendenden und einem empfangenden Datenverarbeitungsblock trotz der Taktverschiebung sicher ist, aber auch keine Anpassschaltungen erfordert, muß die relative Taktverzögerung beim sendenden Datenverarbeitungsblock größer sein als die relative Taktverzögerung beim empfangenden Datenverarbeitungsblock.

Eine zugehörige Taktvorrichtung wird im unabhängigen Anspruch 2 unter Schutz gestellt. Die Realisierung der N verzögerten Zwischentakte aus dem Grundtakt erfolgt vorzugsweise über eine Verzögerungseinrichtung mittels einer Verzögerungskette, an deren Abgriffen die Zwischentakte abgreifbar sind. Jeder dieser Zwischentakte speist mindestens einen Datenverarbeitungsblock innerhalb der monolithisch integrierten Schaltung. Die Datenübergabe zwischen einzelnen Datenverarbeitungsblöcken erfolgt derart, daß der Zwischentakt des sendenden Datenblocks eine relativ größere Verzögerung aufweist als der Zwischentakt des empfangenden Datenblocks.

Der Hauptvorteil der Erfindung besteht im wesentlichen in zwei Aspekten. Zum ersten werden die kritischen steilen Stromspitzen wesentlich kleiner und zum zweiten wird die Anzahl der Stromspitzen innerhalb einer Taktperiode T erhöht. Die geringere Höhe der Stromspitzen reduziert die direkte Störwirkung und ihre dichtere Verteilung erleichtert die Abblockmaßnahmen, da das Störspektrum zu höheren Frequenzen hin verschoben wird.

Zweckmäßig ist, daß die Maxima der mit den Zwischentakten verkoppelten Stromspitzen, sowohl in ihrer Höhe als auch in ihrem zeitlichen Abstand möglichst gleichmäßig verteilt sind. Die gleichmäßige Höhe der Stromspitzen läßt sich durch die gegenseitige Abgrenzung der einzelnen Datenverarbeitungsblöcke bei der Schaltungsauslegung vorgeben. Dabei soll jeder Datenverarbeitungsblock im normalen Betriebsfall etwa gleich viele synchron angesteuerte Schaltelemente enthalten, wobei deren unterschiedliche Größen mit zu berücksichtigen sind. Der Anteil an asynchronen Schaltelementen in jedem Datenverarbeitungsblock tritt dahinter zurück, da deren Schaltzeitpunkte in der Regel nicht mit dem taktgesteuerten Schaltzeitpunkt zusammenfallen und daher einen geringeren Beitrag zur taktverkoppelten Stromspitze liefern. Wenn N Zwischentakte erzeugt werden, dann reduziert sich die Amplitude der Stromspitzen theoretisch um den Faktor N. Der reale Spitzenwert weicht jedoch in der Praxis von diesem Wert mehr oder weniger ab, weil einmal die funktionelle Abgrenzung der Datenverarbeitungsblöcke vorgegebenen Zwängen folgen muß und auch die Anzahl der synchronen Schaltfunktionen von Takt zu Takt unterschiedlich sein kann. Wenn dabei die maximal auftretende Stromspitze zwei- oder dreimal so hoch ist, wie das Mittel aus den anderen Stromspitzen, dann ist die Störbefreiung im Vergleich zur reinen Grundtaktansteuerung immer noch deutlich besser. Denn die resultierende Stromspitze hat im Vergleich zur alten Stromspitze nur den Wert 2/N bzw. 3/N. In der Regel ist dabei N größer/gleich 8. Für höhere Werte von N werden derartige Ausreißer noch weniger wirksam, weil die Absenkung der Stromspitzen insgesamt auch größer ist. Für die Abblockmaßnahmen bleibt die erhöhte Frequenz nach wie vor wirksam und der Ausreißer wirkt sich eigentlich nur über seinen Differenzwert zum Mittel aus den anderen Stromspitzen aus.

Die zeitliche Gleichverteilung der Stromspitzen wird durch die Gleichförmigkeit der einzelnen Verzögerungsstufen in der Verzögerungskette erreicht. Die Anpassung der Gesamtverzögerungszeit an die Periode des Grundtaktes erfolgt zweckmäßigerweise durch eine Regelschaltung. Ein Beispiel für eine derartige geregelte Verzögerungseinrichtung zeigt die eigene Europäische Patentanmeldung EP 0 117 669 A. Wenn N unterschiedliche Zwischentakte vorliegen, dann liegt die Grundfrequenz der resultierenden Stromspitzen um den Faktor N über der Frequenz des Grundtaktes. Dadurch verschiebt sich in gleicher Weise das Spektrum der Störsignale gegenüber dem Nutzsignal zu höheren Frequenzen, wodurch die internen und externen Abblockmaßnahmen wirkungsvoller werden.

Schließlich kann das Taktaufteilungsverfahren auch mit dem eingangs erwähnten Modulationsverfahren auf einfache Weise kombiniert werden. Das Modulationssignal ist dabei ein vorgegebenes Signal mit einer zum Grundtakt relativ niedrigen Frequenz, ein Zufallssignal oder ein Pseudozufallssignal, dessen Periode wesentlich größer als die Periode des Grundtaktes ist. Durch eine derartige Modulation des Grundtaktes oder der Verzögerungszeiten der Zwischentakte kann das Spektrum der Störsignale gleichsam die freien Frequenzbereiche zwischen den Zwischentakten besetzen. Eine Absenkung der jeweiligen Störspitze erfolgt dadurch zwar nicht, aber das Störsignal tritt auf wechselnden Frequenzen auf und trägt daher weniger zu einer Anregung oder Signalverkopplung eines anderen Schaltkreises bei. Dadurch, daß die Zwischentakte den zeitlichen Abstand T/N aufweisen, muß das Modulationssignal über seine Frequenz- oder Phasenänderung nur diesen relativ kleinen Bereich überdecken.

Die Erfindung und vorteilhafte Weiterbildungen werden nun anhand der Figuren der Zeichnung näher erläutert:
Fig. 1 zeigt schematisch als Blockschaltbild die wesentlichen Funktionseinheiten einer Takteinrichtung nach der Erfindung,
Fig. 2 zeigt im Zeitdiagramm schematisch drei gegeneinander verzögerte Zwischentakte und die Abfolge zweier zugehöriger Datenübergaben und
Fig. 3 zeigt im Zeitdiagramm schematisch den verbesserten Stromverlauf.

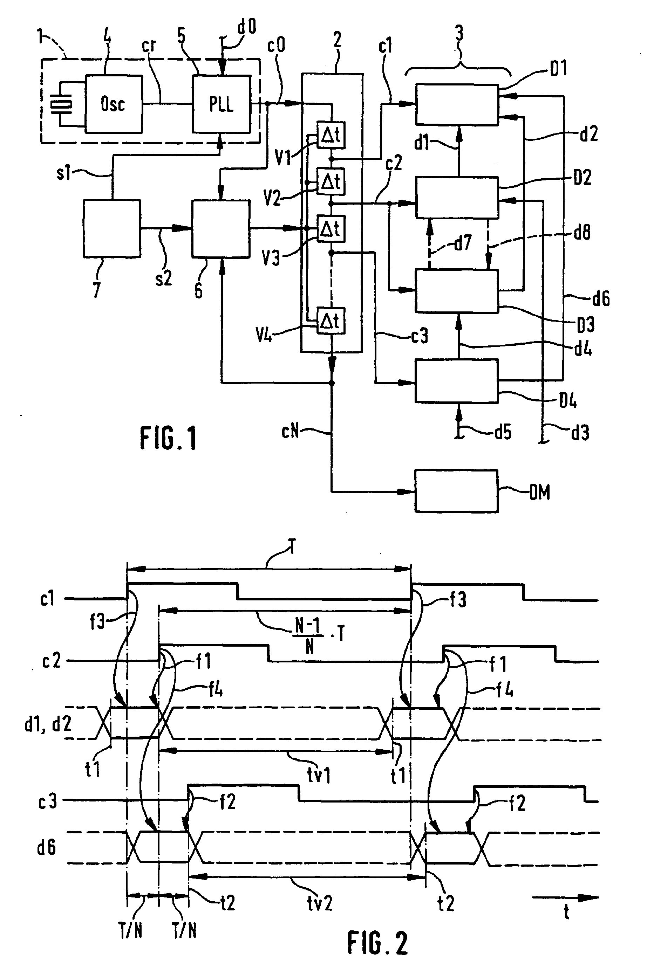

In Fig. 1 ist als Blockschaltbild ein Ausführungsbeispiel einer Takteinrichtung gemäß der Erfindung dargestellt. Eine Taktquelle 1 erzeugt einen Grundtakt c0, der einer Verzögerungseinrichtung 2 zugeführt ist. Die Verzögerungseinrichtung 2 enthält eine Verzögerungskette aus N Verzögerungsstufen V1 bis VN, an deren Abgriffen N Zwischentakte c1 bis cN abgegriffen sind. Jeder dieser N Zwischentakte speist mindestens einen von M Datenverarbeitungsblöcken D1 bis DM, die die eigentliche Datenverarbeitungseinrichtung 3 der monolithisch integrierten Schaltung bilden. Durch die Verzögerung der Zwischentakte gegeneinander ist der Datenaustausch der einzelnen Datenverarbeitungsblöcke untereinander nicht mehr ohne weiteres möglich. Denn es muß sichergestellt sein, daß der sendende Datenverarbeitungsblock bereits stabile Daten liefert, wenn beim empfangenden Datenverarbeitungsblock die Datenübernahme durch die aktive Taktflanke ausgelöst wird. Die vom sendenden Datenverarbeitungsblock durchzuführenden Datenverarbeitungen müssen also auf jeden Fall abgeschlossen sein, bevor die Datenübernahme im empfangenden Datenverarbeitungsblock ausgelöst wird; keinesfalls darf die Datenverarbeitung gerade erst beginnen.

Diese beiden Grundbedingungen für die sichere Datenübemahme sind nur dann gewährleistet, wenn beim empfangenden Datenverarbeitungsblock die relative Verzögerung kleiner ist als beim sendenden Datenverarbeitungsblock und die interne Datenverarbeitung rechtzeitig vor der aktiven Taktflanke des empfangenden Datenverarbeitungsblockes abgeschlossen ist. Durch diese Bedingungen wird die Verarbeitungszeit in den Datenverarbeitungsblöcken beschränkt, wodurch nicht mehr die volle Periode T des Grundtaktes für die Verarbeitung zur Verfügung steht. Bei einer ausreichend hohen Anzahl von Zwischentakten läßt sich der Zeitverlust jedoch gering halten.

Beispiele für Datenbusse zwischen den einzelnen Datenverarbeitungsblöcken sind in Fig. 1 mit den Bezugszeichen d1, d2, d3, d4 und d5 dargestellt. Der Datenbus d1 zwischen den Datenverarbeitungsblöcken D2 und D1 weist nur den kleinsten Verzögerungsschritt T/N der Verzögerungseinrichtung 2 auf. Desgleichen der Datenbus d2 bzw. d4 zwischen den Datenverarbeitungsblöcken D3 und D1 bzw. D4 und D3. Der Datenbus d6 zwischen den Datenverarbeitungsblöcken D4 und D1 hat zwei Verzögerungsschritte T/N zu berücksichtigen, weil diese von den Zwischentakten c3 bzw. c1 angesteuert sind. Die maximal zulässige Datenverarbeitungszeit im Datenverarbeitungsblock D4 ist daher um zwei Verzögerungsschritte T/N gegenüber der vollen Taktperiode T eingeschränkt; mindestens in Bezug auf die über den Datenbus d6 zu übertragenden Daten, denn für die Daten auf dem Datenbus d4 gilt das nicht. Noch größer ist die zeitliche Einschränkung beim Datenbus d3, der den Datenverarbeitungsblock D2 mit Daten aus einem nicht dargestellten Datenverarbeitungsblock speist, dessen Zwischentakt eine unbekannte Verzögerung aufweist, die jedoch größer ist als beim Zwischentakt c3.

Zur Verdeutlichung, daß ein Zwischentakt auch mehr als zwei Datenverarbeitungsblöcke speisen kann, ist der Zwischentakt c2 mit den beiden Datenverarbeitungsblöcken D2 und D3 verbunden. Zwischen ihnen ist auch ein bidirektionaler Datenaustausch über die Datenbusse d7 und d8 möglich, für den streng genommen die volle Periode T des Zwischentaktes c2 zur Verfügung steht.

Eine Zuteilung einzelner Schaltungsbereiche zu den einzelnen Datenverarbeitungsblöcken D1 bis DM muß zunächst nach funktionalen Gesichtspunkten erfolgen. Gemäß der Erfindung sollen die einzelnen Bereiche dabei aber so gegeneinander abgegrenzt sein, daß die mit den jeweiligen Arbeitstaktflanken verkoppelten Stromspitzen im normalen Betriebszustand möglichst gleich hoch sind. Da sich die analogen und digitalen Schaltvorgänge von monolithisch integrierten Schaltungen in Rechenanlagen sehr gut simulieren lassen, kann eine ausgewogene Aufteilung relativ rasch gefunden werden.

Die als Beispiel in Fig. 1 dargestellte Taktquelle 1 enthält einen Quarzoszillator 4, der einen Referenztakt cr für eine Phasenregelschleife 5 erzeugt. Mittels der Phasenregelschleife 5 und einem zugeführten Steuerbefehl d0 läßt sich die Frequenz des Grundtaktes c0 in einem weiten Bereich einstellen. Über eine Regelschaltung 6 wird die Gesamtverzögerungszeit der Verzögerungskette an die Periodendauer T des Grundtaktes c0 angepaßt. Die zueinander identischen Verzögerungsstufen V1 bis VN teilen somit die Periode T in N gleiche Zeitabschnitte T/N ein. Jede Verzögerungsstufe verzögert somit den Grundtakt c0 um ein weiteres Zeitintervall Δt = T/N. Das Ergebnis sind die gleichmäßig verzögerten N Zwischentakte c1 bis cN.

In Fig. 1 ist schließlich auch eine optionale Signalquelle 7 dargestellt, die entweder mit ihrem Ausgangssignal s1 die Phasenregelschleife 5 oder mit ihrem Ausgangssignal s2 mindestens einige Verzögerungen in der Verzögerungseinrichtung 3 moduliert. Wenn als Modulationssignal kein Zufallssignal sondern beispielsweise ein Dreiecks- oder Sägezahnsignal mit einer niederen Grundfrequenz verwendet wird, sind im resultierenden Störspektrum gegebenenfalls noch die Grundwelle und deren Oberwellen auszumachen. Es ist auch möglich, daß nicht alle Datenverarbeitungsblöcke an der Modulation teilnehmen, beispielsweise bei Datenverarbeitungsblöcken, die extern zugängliche Datenschnittstellen aufweisen. Vorzugsweise sind derartige Datenschnittstellen auch mit solchen Zwischentakten gespeist, die gegenüber dem Grundtakt eine geringe Verzögerung aufweisen oder gar direkt durch den Grundtakt gesteuert sind. Das hängt natürlich auch davon ab, ob der Takt für die jeweilige Datenschnittstelle auch extern als Systemtakt zugänglich gemacht wird.

In Fig. 2 sind schematisch im Zeitdiagramm drei Zwischentakte c1, c2 und c3 und die zugehörigen Datenströme auf den Datenbussen d1, d2 und d6 dargestellt. Dabei ist von den Zwischentakten, bei denen es sich in der Regel um nichtüberlappende Zweiphasentakte handelt, vereinfachend nur eine Taktphase gezeigt. Die aktive Taktflanke ist die Anstiegsflanke, die gegebenenfalls sofort einen Datenwechsel am Ausgang des jeweiligen Datenverarbeitungsblocks bewirkt. In dem Zeitdiagramm ist dies durch die geschweiften Pfeile f1, f2 verdeutlicht. Daß die Daten in diesem Bereich noch nicht stabil sind, wird durch die gestrichelten Linien bei den Datenfolgen der Datenverarbeitungsblöcke d1, d2, d6 gezeigt. Die unstabilen Datenzustände werden jedoch noch rechtzeitig vor der Datenübernahme stabil, vgl. die Zeitpunkte tl und t2. Bei der Datenübernahme durch die positive Taktflanke zeigen die geschweiften Pfeile f3, f4, daß die Datenübernahme jeweils nur im stabilen Datenzustand erfolgt. Die Datenverarbeitungszeiten tv1 und tv2 in Fig. 2 sind relativ groß und entsprechen der maximal zulässigen Verarbeitungszeit innerhalb des jeweiligen Datenverarbeitungsblocks. Im Regelfall wird diese Grenze nicht ausgeschöpft, weil die Datenverarbeitung viel früher beendet ist. Beispielsweise ist bei Zweiphasentakten das stabile Ausgangssignal meist dann abgreifbar, wenn die aktive Flanke des Gegenphasentaktes vorliegt.

Das Zeitdiagramm von Fig. 2 zeigt die Periode T des Grundtaktes c0, die selbstverständlich auch für alle Zwischentakte c1 bis cN gilt. Die Zeitverzögerung der Zwischentakte untereinander ist der Verzögerungsschritt T/N, der die Periode T in N gleiche Verzögerungsschritte T/N aufteilt.
Das durch die Verzögerung vorgegebene Intervall T(N-1)/N darf somit bei der Signalverarbeitung im jeweiligen Datenverarbeitungsblock nicht überschritten werden, sonst sind die Daten nicht mehr rechtzeitig stabil. Dieser Grenzwert T(N-1)/N wird indessen durch die bei einer synchronen Schaltungsauslegung fest vorgegebenen "set-up" und "hold" Zeiten weiter verringert.

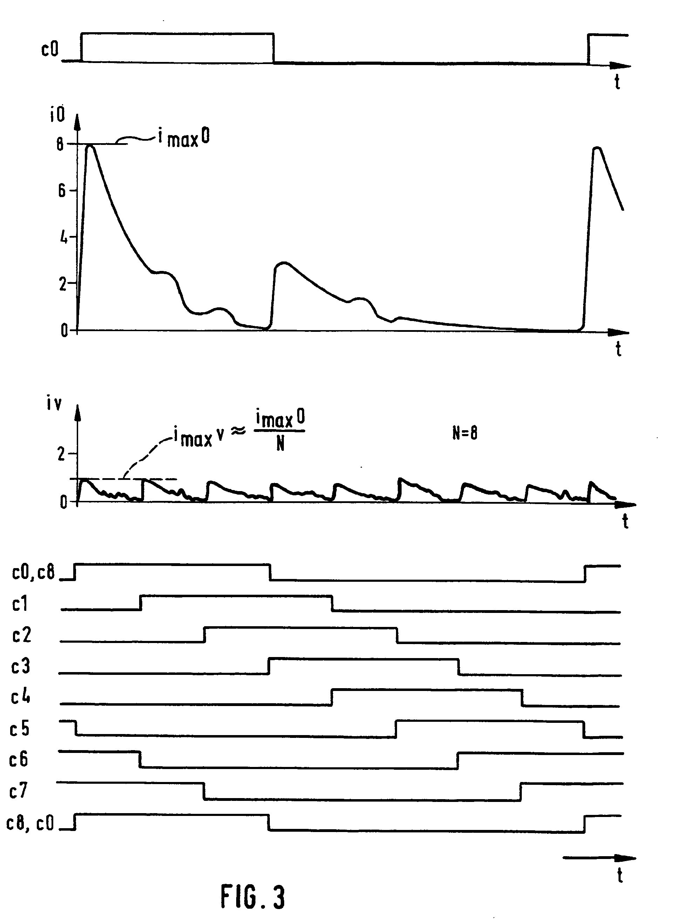

In Fig. 3 ist im Zeitdiagramm einmal schematisch die Gesamtstromaufnahme i0 in Verbindung mit dem Grundtakt c0 und die Stromaufnahme iv in Verbindung mit den verschiedenen Zwischentakten c1 bis c8 dargestellt. Das Strommaximum i_{max 0} des Gesamtstromes i0 wird beim Auftreten der aktiven Flanke des Grundtaktes c0 erreicht. Ein Nebenmaxima liegt etwa bei der Rückflanke oder wird durch einen nicht dargestellten gegenphasigen Grundtakt ausgelöst. Findet nun gemäß der Erfindung eine Aufteilung des Grundtaktes c0 in N=8 Zwischentakte c1 bis c8 statt, dann wird der ursprüngliche Gesamtstrom i0 in eine Folge aus Blockströmen zerlegt. Die Zusammenfassung dieser Blockströme liefert den neuen Gesamtstrom iv, der jedoch statt der einen Stromspitze N=8 Stromspitzen aufweist, deren Maximum i_{max v} jedoch etwa um den Faktor N=8 geringer ist. Ein weiterer Vorteil der Aufteilung, der aber aus Fig. 3 nicht deutlich hervorgeht, ist die Tatsache, daß auch die minimalen Ströme gleichmäßiger verteilt sind. Durch die zeitliche Staffelung der Signalverarbeitung innerhalb einer Taktperiode T finden in der Regel ständige mehr oder weniger viele Schaltvorgänge statt, so daß die Stromaufhahme kaum auf den Wert Null absinkt wie bei der synchronen Verarbeitung mit dem Grundtakt c0. Der Unterschied zwischen der minimalen Stromaufnahme und den Stromspritzen mit i_{max v} wird somit geringer, was ebenfalls zur Störsignalbefreiung beiträgt.

## Patentansprüche

1. Verfahren zur Taktversorgung einer monolithisch integrierten Schaltung, wobei
- ein von einer Taktquelle (1) erzeugter Grundtakt (c0) mit N Zwischentakten (c1 bis cN) gekoppelt ist, die mittels Verzögerungsstufen (V1 bis VN) gegeneinander verzögert sind, wobei die einzelnen Verzögerungen (Δt) innerhalb einer Periode T des Grundtaktes im wesentlichen gleichmäßig verteilt sind,
- jeder der N Zwischentakte (c1 bis cN) mindestens einen von M Datenverarbeitungsblöcken (D1 bis DM) der monolithisch integrierten Schaltung speist,
- zur Datenübergabe zwischen einem sendenden Datenverarbeitungsblock (D2) und einem empfangenden Datenverarbeitungsblock (D1) die Verzögerung (Δt) des dem sendenden Datenverarbeitungsblock zugeordneten Zwischentaktes (c2) größer als die Verzögerung des dem empfangenden Datenverarbeitungsblock zugeordneten Zwischentaktes (c1) vorgegeben wird,
- die Datenverarbeitungsblöcke (D1 bis DM) bei der Schaltungsauslegung so gewählt, werden dass jeder Datenverarbeitungsblock (D1 bis DM) im normalen Betriebsfall etwa gleich viele synchron angesteuerte Schaltungselemente enthält,
**dadurch gekennzeichnet, dass** mindestens ein Teil der von den Verzögerungsstufen (V1 bis VN) abhängigen Verzögerungen (Δt) mittels eines Signals (s2), insbesondere eines Zufallssignals, zeitlich moduliert ist, wobei im zeitlichen Mittel die Verzögerungen (Δt) konstant bleiben.

2. Taktvorrichtung für eine monolithisch integrierte Schaltung mit folgenden Merkmalen:
- eine Taktquelle (1), die einen Grundtakt (c0) liefert, ist an eine aus N hintereinandergeschalteten Verzögerungsstufen (V1 bis VN) gebildete Verzögerungseinrichtung (2) angeschlossen, deren Gesamtverzögerungszeit mindestens eine Periode T des Grundtaktes (c0) umfasst und die N gegeneinander verzögerte Zwischentakte (c1 bis cN) an Abgriffen erzeugt, wobei die einzelnen Verzögerungen (Δt) innerhalb einer Periode T des Grundtaktes liegen,
- die monolithisch integrierte Schaltung enthält M einzelne Datenverarbeitungsblöcke (D1 bis DM), die von jeweils einem der N Zwischentakte (c1 bis cN) gespeist sind, dabei ist die Verzögerung (Δt) eines mit einem sendenden Datenverarbeitungsblock (D2) verkoppelten Zwischentaktes (c2) größer als die Verzögerung (Δt) eines mit einem empfangenden Datenverarbeitungsblock (D1) verkoppelten Zwischentaktes (c1), und
- eine Regelschaltung (6) der Anpassung der Verzögerungen (Δt) der Verzögerungsstufen (V1 bis VN) an die Periodendauer T des Grundtaktes (c0) dient, wobei die Verzögerungen (Δt) der Verzögerungsstufen (V1 bis VN) untereinander im wesentlichen gleich sind, wodurch eine Periode T des Grundtaktes (c0) in N im wesentlichen gleiche Verzögerungsschritte T/N aufgeteilt ist, wodurch die Verzögerung des Zwischentaktes bei einem sendenden Datenverarbeitungsblock (D2) mindestens um den Verzögerungsschritt T/N größer ist als beim zugehörigen empfangenden Datenverarbeitungsblock (D1),
- die Datenverarbeitungsblöcke (D1 bis DM) der monolithisch integrierten Schaltung sind bei der Schaltungsauslegung so gewählt, dass jeder Datenverarbeitungsblock (D1 bis DM) im normalen Betriebsfall etwa gleich viele synchron angesteuerte Schaltungselemente enthält,
**dadurch gekennzeichnet, dass** mindestens ein Teil der von den Verzögerungsstufen (V1 bis VN) abhängigen Verzögerungen (Δt) mittels eines Signals (s2), insbesondere eines Zufallssignals, zeitlich moduliert ist, wobei im zeitlichen Mittel die Verzögerungen (Δt) konstant bleiben.

3. Taktvorrichtung nach Anspruch 2,
**dadurch gekennzeichnet, dass** der von der Taktquelle (1) erzeugte Grundtakt (c0) mittels eines Signals (s1), insbesondere eines Zufallssignals, zeitlich moduliert ist, wobei im zeitlichen Mittel die Frequenz und Phase des Grundtaktes konstant ist.

## Claims

1. A method for supplying a clock pulse for a monolithic integrated circuit, wherein
- a basic clock pulse (c0) supplied by a clock pulse source (1) is coupled with N intermediate clock pulses (c1 to cN), which by means of delay stages (V1 to VN) are delayed relative to one another, wherein the individual delays (Δt) are essentially evenly distributed within a period T of the basic clock pulse,
- each of the N intermediate clock pulses (c1 to cN) supplies at least one of M data processing blocks (D1 to DM) of the monolithic integrated circuit,
- for data transfer between a transmitting data processing block (D2) and a receiving data processing block (D1), the delay (Δt) of the intermediate clock pulse (c2) assigned to the transmitting data processing block is set to be greater than the delay of the intermediate clock pulse (c1) assigned to the receiving data processing block,
- in the circuit design, the data processing blocks (D1 to DM) are chosen such that in the normal operational state, each data processing block (D1 to DM) contains approximately the same number of synchronously triggered circuit elements,
**characterised in that**
at least one portion of the delays (Δt) that are dependent on the delay stages (V1 to VN) is time-modulated by means of a signal (s2), in particular a random signal, wherein in terms of average time, the delays (Δt) remain constant.

2. A clock pulse device for a monolithic integrated circuit with the following characteristics:
- a clock pulse source (1) which supplies a basic clock pulse (c0) is connected to a delay device (2) which is formed ofN delay stages (V1 to VN) that are connected in series, whose overall delay time comprises at least a period T of the basic clock pulse (c0) and which produces, at taps, the intermediate clock pulses (c1 to cN) which are delayed relative to one another, wherein die individual delays (Δt) lie within a period T of the basic clock pulse,
- the monolithic integrated circuit includes M individual data processing blocks (D 1 to DM), which are supplied respectively by one of the N intermediate clock pulses (c1 to cN), wherein the delay (Δt) of an intermediate clock pulse (c2) that is coupled to a transmitting data processing block (D2) is greater than the delay (Δt) of an intermediate clock pulse (c1) that is coupled to a receiving data processing block (D1), and
- a control circuit (6) serves to adapt the delays (Δt) of the delay stages (V1 to VN) to the period duration T of the basic clock pulse (c0), wherein the delays (Δt) of the delay stages (V1 to VN) amongst themselves are essentially equal, through which a period T of the basic clock pulse (c0) is divided up into N essentially equal delay steps T/N, through which the delay of the intermediate clock pulse in the case of a transmitting data processing block (D2) is greater, by at least the delay step T/N, than in the case of the corresponding receiving data processing block (D1),
- in the circuit design, the data processing blocks (D1 to DM) of the monolithic integrated circuit are chosen such that in the normal operational state, each data processing block (D1 to DM) includes an approximately equal number of synchronously triggered circuit elements,
**characterised in that**
at least one portion of the delays (Δt) that are dependent on the delay stages (V1 to VN) is time-modulated by means of a signal (s2), in particular a random signal, wherein in terms of average time, the delays (Δt) remain constant.

3. A clock pulse device as claimed in claim 2, **characterised in that** the basic clock pulse (c0) produced by the clock pulse source (1) is time-modulated by means of a signal (s1), in particular a random signal, wherein in terms of average time, the frequency and the phase of the basic clock pulse is constant.

## Revendications

1. Procédé d'alimentation d'horloge d'un circuit intégré monolithique selon lequel :
- un rythme de base (c0) généré par une source d'horloge (1) est couplé à N rythmes intermédiaires (c1 à cN) retardés les uns par rapport aux autres à l'aide d'étages de retard (V1 à VN), dont les différents retards (Δt) sont essentiellement répartis de manière homogène dans une période T du rythme de base,
- chacun des N rythmes intermédiaires (c1 à cN) alimente au moins l'un des M modules de traitement des données (D1 à DM) du circuit intégré monolithique,
- pour le transfert de données entre un module de traitement des données émettant (D2) et un module de traitement des données réceptionnant (D1), le retard (Δt) du rythme intermédiaire (c2) associé au module de traitement des données émettant est supérieur au retard du rythme intermédiaire (c1) associé au module de traitement de donnée réceptionnant, et
- les modules de traitement des données (D1 à DM) sont choisis pour la configuration du circuit de manière que chaque module de traitement des données (D1 à DM) contienne en mode de fonctionnement normal plus ou moins les mêmes éléments de commutation commandés de manière synchrone,
**caractérisé en ce qu'**
au moins une partie des retards (Δt) dépendant des étages de retard (V1 à VN) est modulée dans le temps à l'aide d'un signal (s2), notamment d'un signal stochastique, sachant que les retards (Δt) restent constants en moyenne temporelle.

2. Dispositif d'horloge pour un circuit intégré monolithique ayant les caractéristiques suivantes :
- une source d'horloge (1) fournissant un circuit de base (c0) est raccordée à un dispositif de retard (2) formé par N étages de retard (V1 à VN) raccordés les uns derrière les autres dont le temps de retard total comprend au moins une période T du rythme de base (c0), et qui génère les N rythmes intermédiaires (c1 à cN) retardés les uns par rapport aux autres sur des prises, sachant que les différents retards (Δt) se trouvent dans une période T du rythme de base,
- le circuit intégré monolithique comprend M modules de traitement des données individuels (D1 à DM) qui sont alimentés par respectivement l'un des N rythmes intermédiaires (c1 à cN) ; le retard (Δt) d'un rythme intermédiaire (c2) couplé à un module de traitement des données émettant (D2) étant par conséquent supérieur au retard (Δt) d'un rythme intermédiaire (c1) couplé à un module de traitement des données réceptionnant (D1),
- un circuit de réglage (6) servant à adapter les retards (Δt) des étages de retard (V1 à VN) à la durée T du rythme de base (c0), les retards (Δt) des étages de retard (V1 à VN) étant essentiellement les mêmes les uns avec les autres, une période T du rythme de base (c0) étant divisée en N étapes de retard T/N essentiellement identiques ce qui rend le retard du rythme intermédiaire dans le cas d'un module de traitement des données émettant (D2) au moins supérieur d'au moins l'étape de retard T/N au module de traitement des données (D1) réceptionnant associé, et
- les modules de traitement des données (D1 à DM) du circuit intégré monolithique sont choisis dans le cadre de la configuration du circuit de manière à ce que chaque module de traitement des données (D1 à DM) comprenne en mode de fonctionnement normal plus ou moins le même nombre d'éléments de commutation commandés de manière synchrone,
**caractérisé en ce qu'**
au moins une partie des retards (Δt) dépendant des étages de retard (V1 à VN) est modulée dans le temps à l'aide d'un signal (s2), notamment d'un signal stochastique, et les retards (Δt) restent constants en moyenne temporelle.

3. Dispositif d'horloge selon la revendication 2,
**caractérisé en ce que**
le rythme de base (c0) généré par la source d'horloge (1) est modulé dans le temps à l'aide d'un signal (s1), notamment d'un signal stochastique, et la fréquence et la phase du rythme de base sont constantes en moyenne temporelle.
